(19) Europäisches Patentamt
European Patent Office
Office européen des brevets

(11) EP 4 600 735 A1

(12) EUROPEAN PATENT APPLICATION

(43) Date of publication:
13.08.2025 Bulletin 2025/33

(21) Application number: 25155459.8

(22) Date of filing: 03.02.2025

(51) International Patent Classification (IPC):
G03F 1/36 (2012.01)    G03F 1/70 (2012.01)
G03F 7/00 (2006.01)    G06N 3/045 (2023.01)

(52) Cooperative Patent Classification (CPC):
G03F 7/705; G03F 1/36; G03F 1/70; G06N 3/045

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 02.02.2024 KR 20240016935

(71) Applicant: Samsung Electronics Co., Ltd.
Suwon-si, Gyeonggi-do 16677 (KR)

(72) Inventors:
• KWAK, Youngchul
  16678 Suwon-si (KR)
• PARK, Seong-Jin
  16678 Suwon-si (KR)
• KANG, Deokyoung
  16678 Suwon-si (KR)
• RYOU, Serim
  16678 Suwon-si (KR)
• RHEE, Seon min
  16678 Suwon-si (KR)

(74) Representative: Arnold & Siedsma
Bezuidenhoutseweg 57
2594 AC The Hague (NL)

(54) **METHOD AND APPARATUS WITH AI MODEL FOR MASK IMAGE GENERATION**

(57) A method for generating a mask image for fabricating a mask includes: generating the mask image from a target pattern using a first artificial intelligence (AI) model; calculating a first loss function based on a difference between the mask image and a mask image corrected according to a mask rule; and updating the first AI model based on the first loss function.

FIG. 4

```
                    ( Start )
                        |
                        v
┌─────────────────────────────────────┐
│ First AI model is used to generate    │──── S110
│ mask image from target pattern        │
└─────────────────────────────────────┘
                        |
                        v
┌─────────────────────────────────────┐
│ Second AI model is used to predict    │──── S120
│ pattern to be generated by mask image │
└─────────────────────────────────────┘
                        |
                        v
┌─────────────────────────────────────┐
│ Loss function is calculated based on  │
│ difference between predicted pattern  │──── S130
│ and target pattern and gradient       │
│ of loss function is backpropagated    │
└─────────────────────────────────────┘
                        |
                        v
┌─────────────────────────────────────┐
│ Update first AI model so that         │──── S140
│ generated mask image complies with    │
│ mask rule                             │
└─────────────────────────────────────┘
                        |
                        v
                    ( End )
```

**Description**

BACKGROUND

1. Field

The description relates to a method and an apparatus for generating a mask image for mask fabrication using an AI model.

2. Related Art

To generate a physical mask used for fabricating semiconductors, optical proximity correction (OPC) that corrects a mask pattern by considering diffraction of light is performed. In the OPC, a shape of the mask may be updated as the mask is corrected according to a mask generation rule determined by a user. In other words, the mask is updated by repeating several corrections according to the pattern that the mask casts.

The OPC method has an advantage in manufacturing masks that meet rules, but the OPC method has a disadvantage that its performance and speed are determined by the user's ability to choose an optimal rule.

SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a method for generating a mask image for fabricating a mask includes: generating a first mask image from a target pattern using a first artificial intelligence (AI) model; determining a first loss function based on a difference between the first mask image and a corrected mask image of the first mask image that is corrected based on mask rules; updating the first AI model based on the first loss function; and generating a second mask image from the target pattern using the updated first AI model.

To fabricate a semiconductor wafer, processes may include a photo process. In the photo process, light radiated from a light source may pass through a pattern of a mask (with diffraction occurring). Because light diffracts as it passes through the pattern of a mask, the corresponding pattern of light cast onto a wafer surface may be different from the pattern of the mask. Therefore, to form a desired target pattern on a wafer, OPC that corrects the pattern of a mask by considering diffraction of light should be performed. According to some embodiments, OPC may be performed through machine learning. OPC based on the machine learning has an advantage of being able to generate an optimized mask by using an AI model trained with training data of mask images.

The determining of the first loss function based on the difference between the mask image and the corrected mask image that is corrected based on the mask rule may include performing an opening operation on the first mask image based on a first mask rule of a minimum pattern size.

The performing of the opening operation on the mask image may include contracting a portion of the first mask image by a predetermined number of pixels and then expanding the portion of the first mask image by the predetermined number of pixels.

The updating of the first AI model based on the first loss function may include updating, based on the first loss function, the first AI model to generate a mask image in which a pattern with a size less than the minimum pattern size is removed from first the mask image.

The determining of the first loss function based on the difference between the mask image and the corrected mask image that is corrected based on the mask rule may include performing a closing operation on the mask image based on a second mask rule of minimum spacing between regions of the mask image.

The performing of the closing operation on the mask image based on the second mask rule minimum pattern spacing may include expanding the first mask image by a predetermined number of pixels and then contracting the first mask image by the predetermined number of pixels.

The updating of the first AI model based on the first loss function may include updating, based on the first loss function, the first AI model to generate a mask image in which patterns with spacing narrower than the minimum spacing become connected to each other.

The method may further include: predicting a casting pattern corresponding to the second mask image using a second AI model; and updating the first AI model based on a second loss function of loss between the target pattern and the predicted casting pattern.

The method may further include predicting a casting pattern corresponding to the first mask image by applying the second AI model to the first mask image, wherein the updating of the first AI model based on the first loss function may include updating the first AI model based on the first loss function and a second loss function of loss between the target pattern and the predicted casting pattern.

In another general aspect, an apparatus for generating a mask image for fabricating a mask includes: one or more processors; and a memory, wherein the memory stores instructions configured to cause the one or more processors perform a process including: generating a first mask image from a target pattern using a first artificial intelligence (AI) model; determining a first loss function based on a difference between the first mask image and a corrected mask image of the first mask image that is corrected based on mask rules; updating the first AI model based on the first loss function; and generating a second mask image from the target pattern using the updated first AI model.

The determining of the first loss function may include performing an opening or closing operation on the first mask image based on a first mask rule regarding a minimum size of a region or based on based on a second mask rule regarding a minimum spacing between regions.

The performing of the opening operation on the mask image may include eroding the mask image and then dilating the mask image; and the performing the closing operation on the mask image based on the second mask rule regarding a minimum spacing between regions may include dilating the mask image and then eroding the mask image.

The first AI model may include a neural network that simulates photolithography, and the first mask image may be an image of a photolithographic mask that photolithographically corresponds to the target pattern.

The process further may include inputting the first mask image to a second AI model that models light diffraction, and the second AI model may predict a diffraction pattern based on the first mask image.

The process may further include updating the first AI model based on the predicted diffraction pattern and the target pattern.

After the updating of the first AI model based on the predicted diffraction pattern and the target pattern, the first AI model may generate another mask image in which regions with spacing narrower than a minimum spacing are deleted.

The process may further include: predicting a diffraction pattern of the second mask image using a second AI model; and updating the updated first AI model based on a second loss function between the target pattern and the predicted diffraction pattern.

The process may further include: predicting a diffraction pattern of the first mask image using a second AI model, and the updating of the first AI model based on the first loss function may include updating the first AI model based on the first loss function and a second loss function of loss between the target pattern and the predicted diffraction pattern.

In another general aspect, a method performed by a computing device includes: inputting an image of a target pattern to an optical proximity correction (OPC) neural network, the OPC neural network inferring, based on the image of the target pattern, a mask image corresponding to the target pattern; inputting the mask image, or a version thereof, to a lithography simulation (LS) neural network, the LS neural network, inferring from the mask image or version thereof, a predicted pattern corresponding to the target pattern.

The method may further include correcting the mask image to comply with a photolithography rule and updating the OPC neural network based on the corrected mask image.

In another general aspect, an apparatus for generating a mask image for fabricating a mask includes: a first artificial intelligence (AI) model configured to train to generate the mask image from a target pattern; a second AI model configured to train to generate a prediction of a pattern formed on a wafer by the mask image; and a mask verifier configured to determine a first loss function based on a difference between the mask image and a corrected mask image according to mask rules and backpropagate a gradient of the first loss function to the first AI model, wherein the first AI model further configured to be updated using the gradient of the first loss function and a gradient of a second loss function transferred from the second AI model.

The second loss function may be determined based on a difference between the target pattern and the predicted pattern generated by the second AI model.

BRIEF DESCRIPTION OF THE DRAWINGS

FIG. 1 illustrates a photo process for fabricating a semiconductor wafer according to one or more embodiments.
FIG. 2A illustrates a target pattern according to one or more embodiments.
FIG. 2B illustrates a mask and a pattern cast onto a wafer surface fabricated without optical proximity correction (OPC) according to one or more embodiments.
FIG. 2C illustrates a mask fabricated through OPC and a corresponding pattern cast onto a wafer surface according to one or more embodiments.
FIG. 3 illustrates a mask generation apparatus according to one or more embodiments.
FIG. 4 illustrates a mask generation method according to one or more embodiments.
FIG. 5 illustrates a closing operation according to one or more embodiments.

FIG. 6 illustrates a difference between an original image and a closed image according to one or more embodiments.

FIG. 7 illustrates an opening operation according to one or more embodiments.

FIG. 8 illustrates a difference between an original image and an opened image according to one or more embodiments.

FIG. 9 illustrates a mask generation apparatus according to one or more embodiments.

FIG. 10 illustrates a mask generation method according to one or more embodiments.

FIG. 11 illustrates a neural network according to one or more embodiments.

FIG. 12 illustrates a mask generation apparatus according to another embodiment.

Throughout the drawings and the detailed description, unless otherwise described or provided, the same or like drawing reference numerals will be understood to refer to the same or like elements, features, and structures. The drawings may not be to scale, and the relative size, proportions, and depiction of elements in the drawings may be exaggerated for clarity, illustration, and convenience.

## DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As used herein, the term "and/or" includes any one and any combination of any two or more of the associated listed items. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Throughout the specification, when a component or element is described as being "connected to," "coupled to," or "joined to" another component or element, it may be directly "connected to," "coupled to," or "joined to" the other component or element, or there may reasonably be one or more other components or elements intervening therebetween. When a component or element is described as being "directly connected to," "directly coupled to," or "directly joined to" another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

The artificial intelligence models (AI models) described herein are machine learning models that learn at least one task and can be implemented as a computer program (instructions) executed by a processor. The task learned by the AI model may involve solving a problem through machine learning or a work to be performed through machine learning. AI models may be implemented as computer programs that run on computing devices, downloaded over a network, or sold in a product form. Alternatively, an AI model may be connected to various devices through a network. Also, an AI model may be interoperable with various devices through a network.

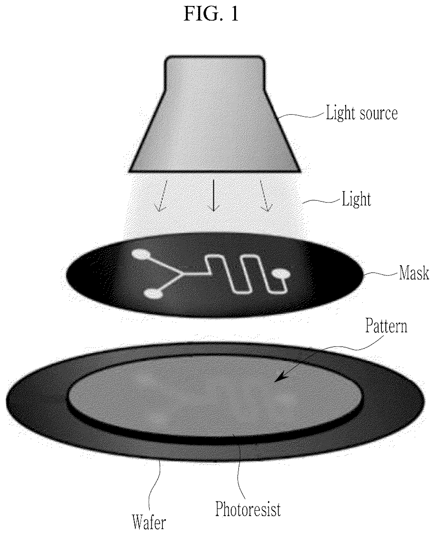

FIG. 1 illustrates a photo process for fabricating a semiconductor wafer according to one or more embodiments.

To fabricate (or manufacture) a semiconductor wafer (e.g., a DRAM, a flash memory, a logic semiconductor, or the like), processes may include a wafer fabricating process, an oxidation process, a photo process, an etching process, a deposition and ion implantation process, a metal wiring process, an electric die sorting process, and a packaging process, for example. Referring to FIG. 1, in the photo process, light radiated from a light source may pass through a pattern of a mask (with diffraction occurring). The pattern-passed light contacts the surface of a wafer on which a photoresist has been applied, and a desired circuit pattern may be generated on the wafer by reaction between the pattern-passed light and the photoresist.

The pattern is printed on the wafer due to a difference in a property of the photoresist appearing in the portion of the wafer that receives the light that passes through the pattern of the mask and the portion that does not receive the light. For example, when a positive photoresist is used, the portion that receives light on the wafer may be removed, and when a negative photoresist is used, the portion that does not receive light on the wafer may be removed.

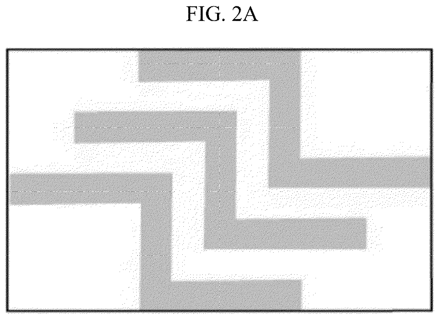

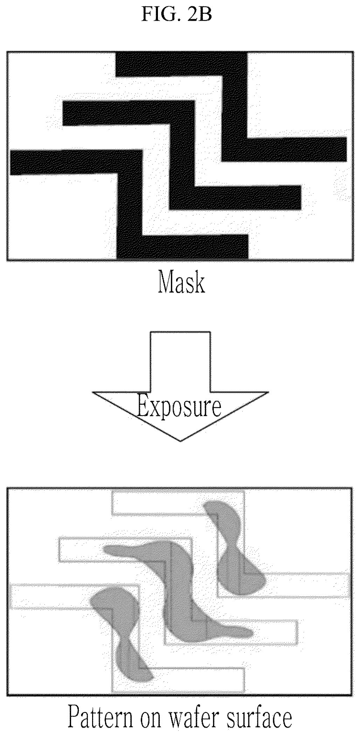

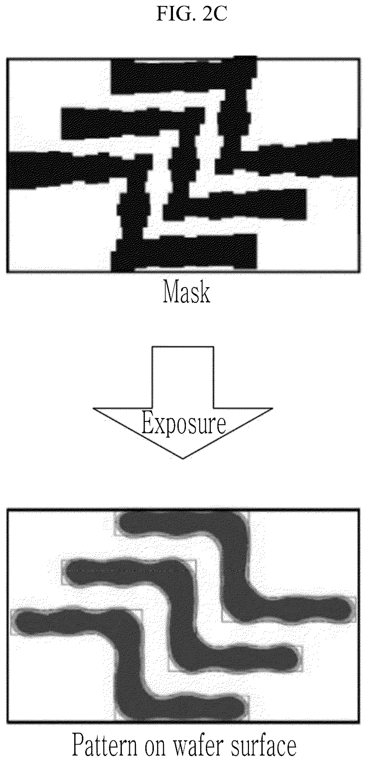

FIG. 2A illustrates a target pattern according to one or more embodiments, FIG. 2B illustrates a mask and a pattern cast onto a wafer surface fabricated without optical proximity correction (OPC) according to one or more embodiments, and FIG. 2C illustrates a mask fabricated through OPC and a corresponding pattern cast onto a wafer surface according to one or more embodiments.

Because light diffracts as it passes through the pattern of a mask, the corresponding pattern of light cast onto a wafer surface may be different from the pattern of the mask. Referring to the example of FIG. 2A and FIG. 2B, when a mask having the same pattern as the target pattern shown in FIG. 2A is used, it can be seen that the pattern formed/etched on the wafer surface after the exposure of light is very different from the target pattern.

However, referring to FIG. 2A and FIG. 2C, when a mask with a pattern for the target pattern shown in FIG. 2A is generated in consideration of diffraction, a pattern similar to the intended target pattern may be formed on the wafer surface after light exposure.

Therefore, to form a desired target pattern on a wafer, OPC that corrects the pattern of a mask by considering diffraction of light should be performed.

According to some embodiments, OPC may be performed through machine learning. OPC based on machine learning has an advantage of being able to generate an optimized mask by using an AI model trained with training data of mask images.

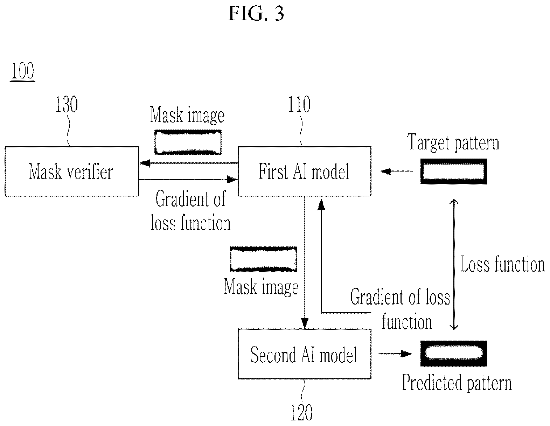

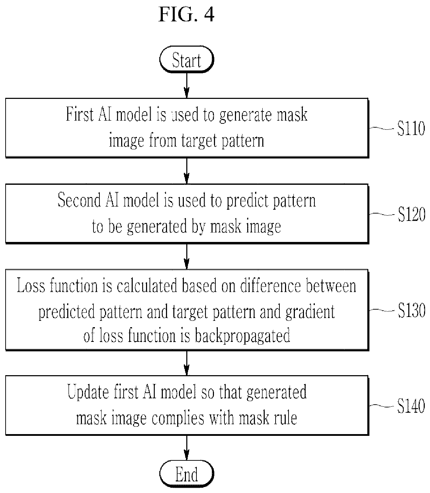

FIG. 3 illustrates a mask generation apparatus according to one or more embodiments. FIG. 4 illustrates a mask generation method according to one or more embodiments.

Referring to FIG. 3, a mask generation apparatus 100 may include a first AI model 110, a second AI model 120, and a mask verifier 130. The first AI model 110 may be referred to as an OPC network (OPCNet) and the second AI model 120 may be referred to as a Lithography Simulation Network (LithoNet).

Referring to FIG. 4, the first AI model 110 may generate, from the target pattern, a mask image for forming (casting), onto a wafer, a pattern that is the same as, or highly similar to, the target pattern (S110).

The first AI model 110 may be trained with various training patterns to become capable of generating (inferring) mask images that cast/form respective patterns nearly identical to the respective training patterns inputted to the first AI model 110. Thereafter, for an arbitrary target pattern for which a mask is desired, the trained first AI model 110 may infer from the arbitrary target pattern a corresponding mask image capable of forming the arbitrary target pattern (or a very close approximation thereof).

Referring to FIG. 4, the second AI model 120 may receive the mask image inferred/generated by the first AI model 110 and predict based thereon a cast pattern (as if onto a wafer) formed by the mask (S120).

When the first AI model 110 is being trained using various training patterns, an error may occur due to a difference between the distribution of training data and the distribution of test data. To improve performance/accuracy of the mask images generated by the first AI model 110, this error may be reduced by updating the first AI model 110 (e.g., weights thereof) to minimize the error, e.g., by backpropagation or the like.

To elaborate on the loss minimization, referring to FIG. 4, a loss function of loss between (i) a pattern predicted based on a simulation result of a mask image generated/predicted by the first AI model 110 and (ii) the corresponding target pattern. The loss function may be determined and a gradient of the loss function may be backpropagated to the first AI model 110 (S130). In some embodiments, because the first AI model 110 may be updated even during the inference process in which the mask image for the target pattern is generated by the first AI model 110, performance (e.g., suitability) of the mask image with respect to the target pattern may be improved.

In some embodiments, the mask verifier 130 may verify whether the mask image generated by the first AI model 110 satisfies mask rules and may update the first AI model 110 in a way that causes the first AI model 110 to subsequently generate the mask image (for the target pattern) such that the mask image satisfies the mask rules (S140).

For example, the mask rules may include a rule regarding a minimum size of regions included in the mask image (e.g., a size limitation of the regions) or a rule regarding a minimum spacing between regions/parts (e.g., a spacing limitation of the regions/parts). The mask rules may be determined in advance according to a physical limitation in a fabricating process of the semiconductor, a limitation in semiconductor fabricating equipment, or the like.

Although the OPC-based machine learning model may generate a mask image that forms a pattern very similar to the target pattern, the mask image may not be suitable to be used as an actual physical mask due to limitations in the fabricating process of the semiconductor, limitations in the fabricating equipment of the semiconductor, or the like. For example, it is difficult to implement a pattern with, for example, (i) a feature/region that is smaller than the minimum size in the fabricating process of the semiconductor, or is smaller than the limit of the fabricating equipment of the semiconductor (or the like), or (ii) with a region narrower than the minimum spacing predetermined limit of the semiconductor fabricating process.

Therefore, the first AI model 110 may be updated based on a difference between the mask image generated by the first AI model 110 and version of the mask image that has been corrected based on the mask rules (e.g., by the mask verifier 130).

In some embodiments, the mask verifier 130 may determine a first loss function between the mask image generated by the first AI model 110 and a version of the mask image as corrected based on the mask rules. That is, the mask image generated by the first AI model 110 may be passed to the mask verifier 130 which may apply rules (e.g., related to the equipment/process limitations) thereto to generate the updated/corrected version of the mask image. Then, the mask verifier 130 may backpropagate the first loss to the first AI model 110, for example by calculating a gradient of the first loss function. In this way, weights (or other parameters) of the first AI model 110 may be updated to minimize the gradient of the first loss function.

In the inference step according to one or more embodiments, the mask image inferred/generated by the first AI model 110 may be passed to the second AI model 120 as well as the mask verifier 130, and then the first AI model 110 may be updated using, at the same time, both (i) a gradient of a second loss function (backpropagated from the second AI model 120) and (ii) the gradient of the first loss function backpropagated from the mask verifier 130. The first AI model 110 as updated, at one time, based on the loss functions calculated by the second AI model 120 and the mask verifier 130 may be better able to generate the mask image capable of forming a pattern closest to (or nearly the same as) the corresponding target pattern while also meeting the mask rules. Incidentally, the second loss function may be a loss of the pattern predicted by the second AI model 120 relative to the target pattern.

Alternatively, after the first AI model 110 is updated based on the gradient of the first loss function backpropagated from the mask verifier 130, the updated first AI model 110 may generate a new mask image for the same target pattern. The new mask image generated by the first AI model 110 as updated based on the first loss function (calculated by the mask verifier 130) may be inputted to the second AI model 120 for optical simulation, and the first AI model 110 may be updated again based on the gradient of the second loss function backpropagated from the second AI model 120. Thereafter, the first AI model 110 updated by the mask verifier 130 may generate a new mask image capable of forming a pattern close to the target pattern or substantially the same as the target pattern while meeting the mask rules. In another approach, the order may be reversed; the first AI model 110 may be updated according to the second loss function of the second AI model 120 and may then be updated according to the first loss function of the mask verifier 130.

As described above, for a mask image generated during the inference process by the AI model, a region of the mask image that violates the mask rules regarding mask image size and spacing (as may be generated in the mask image during the inference process by the AI model) may be corrected, so that a quality of the mask can be dramatically improved. Additionally, because the quality of physical photolithography masks actually implemented from mask images generated by the AI model increases, cost and time efficiency in semiconductor production can be significantly improved.

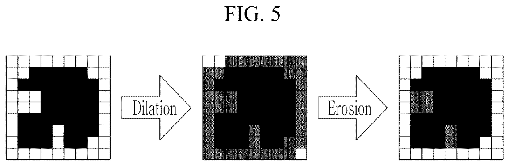

Described next, with reference to FIGS. 5 to 8, is a method of the mask verifier 130 updating the first AI model 110 based on a difference between (i) the mask image generated by the first AI model 110 and (ii) the mask image as corrected by the mask verifier 130 based on the mask rules of the mask verifier 130.

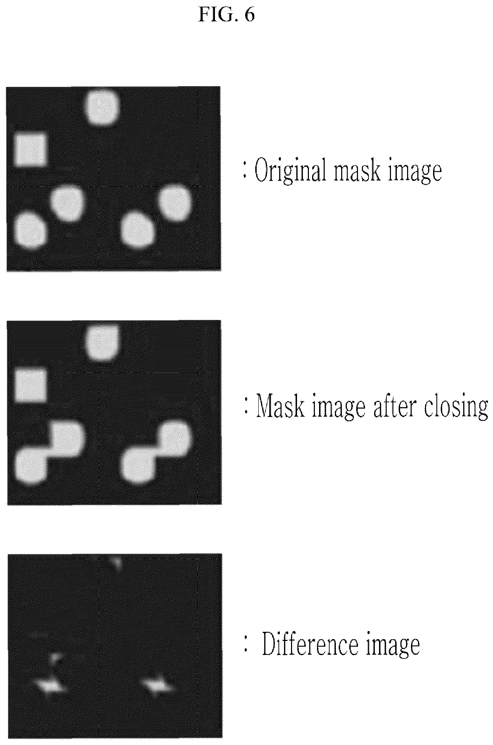

FIG. 5 illustrates a closing operation according to one or more embodiments and FIG. 6 illustrates a difference between an original image and a closed image according to one or more embodiments. The operation is a "closing" in that it may close up narrow spaces between features of a mask image.

In some embodiments, the mask verifier 130 may perform a closing operation on the mask image generated by the first AI model 110 to correct the mask image based on the inter-region spacing limitation (spacing between parts/regions of the mask image).

Referring to FIG. 5, the mask verifier 130 may perform the closing operation by dilating (i.e., expanding/enlarging) a region/feature in the mask image by a unit of one pixel (for example) and then eroding (i.e., contracting/shrinking) the region/feature in the mask image in a unit of one pixel. The pixels displayed in black in FIG. 5 show dilated and eroded regions of an example mask image. The expansion may be thought of as a kind of ballooning outward (e.g., by one pixel outward) of a pattern, and then deflating the ballooned pattern (e.g., by one pixel inward).

The mask verifier 130 may expand regions in the mask image by a predetermined number of pixels (k), and then may contract the expanded regions in the mask image by the same number of pixels (k). The number (k) of the dilation and the erosion steps may be determined in advance according to the mask rule regarding the minimum spacing regions/-features. For example, when the minimum region spacing in the mask rule is 5 pixels, the mask verifier 130 may dilate the regions in the mask image 5 times, 1 pixel at a time, and then may erode the regions in the mask image 5 times, which has the effect of thereby removing spacing between the regions of 5 pixels or less from the mask image generated by the first AI model 110.

FIG. 5 shows a change of a region according to the closing operation in which one dilation is performed and then one erosion is performed. Referring to FIG. 5, where white pixels represent mask opening and black pixels represent solid mask, in a portion/region of the mask image that violates the minimum spacing rule may be corrected as the mask verifier 130 performs the closing operation in which one dilation is performed and then one erosion is performed. For example, in the mask image, regions/features having a spacing therebetween which is narrower than the minimum spacing can be connected to their neighbor regions by the closing operation. In the last image of FIG. 5, gray pixels represent formerly open mask pixels that have become solid mask pixels.

Referring to FIG. 6, an example original mask image generated by the first AI model 110 includes regions having a spacing therebetween which is smaller than a predetermined minimum spacing. Because the mask verifier 130 performs the closing operation on the mask image, all of the regions having the relatively narrow spacing within the mask image may become connected to each other. That is, the mask verifier 130 may perform the closing operation on the mask image so that the mask image satisfies the spacing limitation between the patterns. Equation 1 below represents a loss function based on the closing operation of the mask verifier 130.

Equation 1

$$L_{inter} = \sum_{(x,y) \in S} \left| sg\big(I(x,y)\big) - C\big(I(x,y)\big) \right|^2, \qquad S = \{(x,y)|I(x,y) = 0\}$$

Referring to Equation 1, $C(I(x,y))$ represents the closing operation for a portion ( $S = \{(x,y)|I(x,y) = 0\}$, which represents the region in the mask image generated by the first AI model 110. $sg(I(x,y))$ ("sg" stands for "stop gradient") represents a portion where update of the gradient is stopped. Referring to Equation 1, the mask verifier 130 may determine a loss function based on a difference between a mask image for which the closing operation has been performed and a mask image for which the update of the gradient has stopped. Weights of the first AI model 110 may be updated to configure the first AI model to generate a mask image in which an edge of the regions in the mask image is removed or in which the regions with a spacing narrower than the minimum spacing of the mask rule are connected to each other based on the gradient of the loss function according to Equation 1. In short, the loss between the original mask image and the closed version of the mask image may be used to train/update the first AI model 110 so that it effectively learns the closing behavior/modifications of the verifier 130.

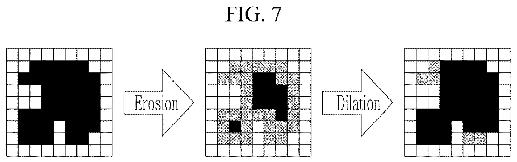

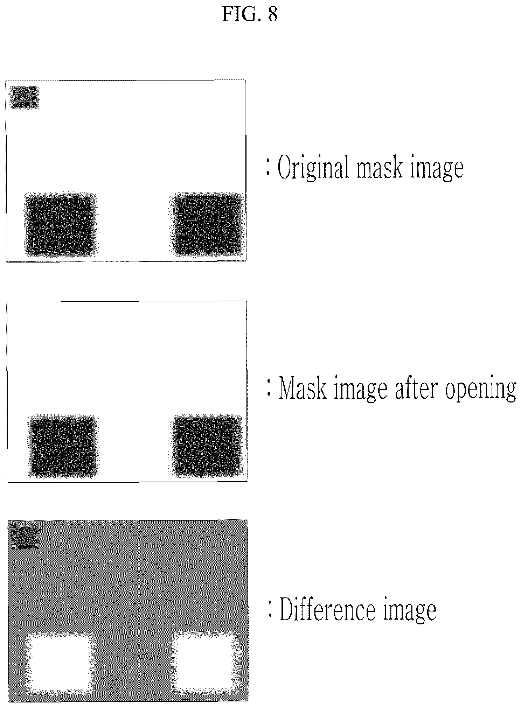

FIG. 7 illustrates an opening operation according to one or more embodiments and FIG. 8 illustrates a difference between an original image and an opened image according to one or more embodiments. The operation is an "opening" in that it may delete regions/features in a mask image that are too small.

In some embodiments, the mask verifier 130 may perform an opening operation on the mask image generated by the first AI model 110 to correct the mask image based on the region size limitation.

Referring to FIG. 7, the mask verifier 130 may perform the opening operation by eroding (i.e., contracting) a region in the mask image (the dark region in FIG. 7) by a unit of one pixel and then dilating (i.e., expanding) the region in the mask image by a unit of one pixel. The pixels displayed in black in FIG. 7 show examples of the patterns of the mask image. In the last image of FIG. 7, gray pixels (solid mask) represent formerly black pixels (mask opening) that have become pixels representing solid/opaque mask.

When the mask verifier 130 performs the opening operation, the mask verifier 130 may contract regions in the mask image by a predetermined number (k) of pixels, and then may expand the contracted regions in the mask image by the same number of pixels. For example, the number k of one-pixel dilations and erosions may be determined in advance according to the mask rule regarding the minimum region size. For example, when the minimum size of the region/feature in the mask rule is 3 pixels, the mask verifier 130 may erode the region in the mask image 3 times, 1 pixel at a time, and then may dilate the region in the mask image 3 times to remove the pattern with a size of 3 pixels or less from the mask image generated by the first AI model 110.

FIG. 7 shows a change of a region according to the opening operation in which one erosion is performed and then one dilation is performed. Referring to FIG. 7, a portion/region that violates the mask rule regarding the minimum region size may be corrected as the mask verifier 130 performs the opening operation in which one erosion is performed and then one dilation is performed. For example, a region having a size smaller than the minimum size may be deleted from the mask image. In FIG. 7, the gray pixels in the last image represent pixels that have changed from solid-material mask pixels (white pixels in the first image) to mask-opening pixels (pixels that represent places where there is no mask material).

Referring to FIG. 8, an example of an original mask image generated by the first AI model 110 includes a region with a size smaller than a predetermined minimum size. Because the mask verifier 130 performs the opening operation on the mask image, regions of relatively small size within the mask image may be deleted. That is, the mask verifier 130 may perform the opening operation on the mask image so that the mask image satisfies the region size limitation. Equation 2 below represents a loss function based on the opening operation of the mask verifier 130.

Equation 2

$$L_{intra} = \sum_{(x,y)\in S} \left| I(x,y) - sg\left(O\big(I(x,y)\big)\right) \right|^2, \qquad S = \left\{ (x,y) | D\left(O\big(I(x,y)\big)\right) = 0 \right\}$$

Referring to Equation 2, $O(I(x,y))$ represents the opening operation for a portion ( $S = \{(x,y)|D(O(I(x,y))) = 0\}$ ) that represents the pattern in the mask image generated by the first AI model 110, and D represents a dilation operation. Referring to Equation 2, the mask verifier 130 may determine a difference between (i) the mask image in which update of the gradient has stopped and (ii) the original mask image as the loss function after the opening operation is completed. Based on the gradient of the loss function according to Equation 2, weights of the first AI model 110 may be updated to configure the first AI model to be able to generate a mask image in which regions having size smaller than the minimum size of the mask rule are removed from the mask image.

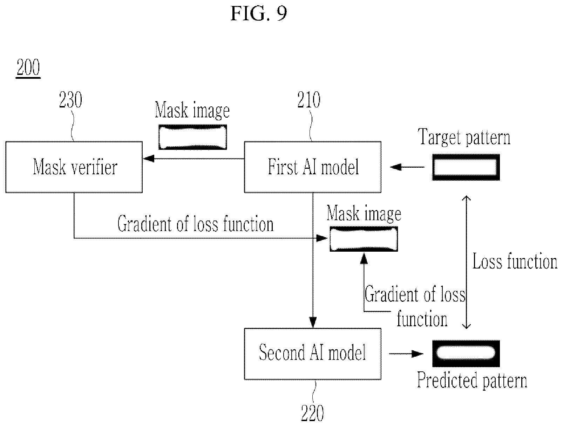

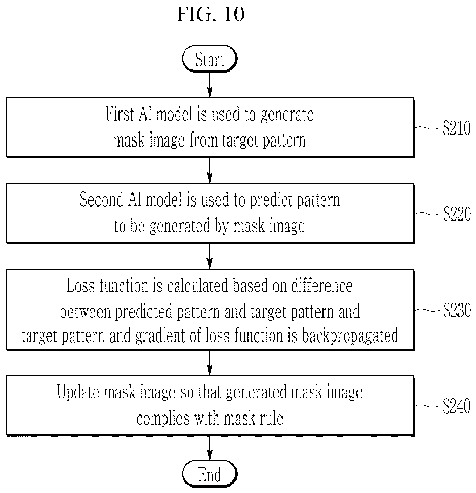

FIG. 9 illustrates a mask generation apparatus according to one or more embodiments and FIG. 10 illustrates a mask generation method according to one or more embodiments.

Referring to FIG. 9, the mask generation apparatus 200 may include a first AI model 210, a second AI model 220, and a mask verifier 230.

Referring to FIG. 10, the first AI model 210 may generate/infer a mask image for forming a pattern that is nearly the same as a target pattern from an input of the target pattern to the first AI model 210 (S210). The first AI model 210 may also be referred to as the OPCNet insofar as it has been trained to provided OPC functionality in its inferencing.

The first AI model 210 may be trained with various training patterns to learn to generate mask images that form/cast patterns nearly identical (or close) to respective training patterns. The thus-trained first AI model 210 may generate/infer a mask image capable of forming a nearly same pattern as a corresponding target pattern, and may do so from (or based on) the target pattern which is inputted to the first AI model 210.

Referring to FIG. 10, the second AI model 220 may predict a pattern formed/cast by light passing through a hypothetical mask (e.g., by modeling diffraction) if fabricated from the mask image generated by the first AI model 210 (S220). That is, the second AI model 220 realistically models, by inference, light passing through the mask image inferred/predicted by the first AI model 210. The second AI model 220 may also be referred to as the LithoNet, insofar as it simulates light patterns in photolithography.

The first AI model 210 may be trained with training data, which may include training pairs, and each pair may include a training pattern and a ground truth mask image for the training pattern. When the first AI model 210 is trained using the various training patterns, an error may occur due to a difference between a distribution of training data and a distribution of test data. That is, there may be an error between the ground truth mask image of a given pair and the mask image predicted by the first AI model 210 based on the given training pattern. In order to improve performance/accuracy of the mask images generated by the first AI model 210, the first AI model 210 may be updated (e.g., by backpropagation) to minimize the aforementioned errors of the training pairs.

Referring to FIG. 10, generally speaking, a loss function may be determined as a function of loss between (i) a pattern predicted from a simulation/inference result performed on the mask image generated by the first AI model 210 and (ii) the target pattern, and the mask image generated by the first AI model 210 may be updated based on a gradient of the loss function (S230). In some embodiments, the mask image generated by the first AI model 210 (for the target pattern) may be updated in the inference process, so that the mask image is configured to form a pattern closer to the target pattern on the wafer.

In one or more embodiments, the mask verifier 230 may verify whether the mask image generated by the first AI model 210 satisfies mask rules and may update the mask image to satisfy the mask rules (S240). The mask verifier 230 may calculate a loss function for updating the mask image based on a difference between the mask image generated by the first AI model 210 and a version of the mask image that has been corrected based on the mask rules.

In the inference step, the mask image generated by the first AI model 210 may be inputted to the second AI model 220 and to the mask verifier 230, and then the mask image generated by the first AI model 210 may be updated at one time using both a corresponding first loss function determined by the second AI model 220 and a corresponding second loss function determined by the mask verifier 230. The mask image updated based on the loss functions determined by each of the second AI model 220 and the mask verifier 230 may be configured to form a pattern closer to the target pattern or substantially the same as the target pattern while meeting the mask rule.

In the mask image generated during the inference process by the AI model, a region that violates the mask rules regarding mask size and mask spacing can be corrected, so that a quality of the mask is dramatically improved. Additionally, because the mask image may be directly updated from the loss functions determined to comply with mask rules, inference performance can be improved by the AI model.

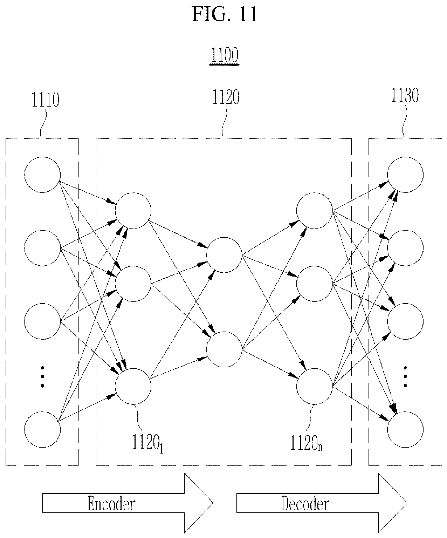

FIG. 11 illustrates an example neural network implementation of the AI model according to one or more embodiments.

Referring to FIG. 11, the first AI model according to one or more embodiments may have a neural network structure including an input layer 1110, a hidden layer portion 1120, and an output layer 1130. The neural network 1100 may have an encoder-decoder structure, and may constitute a portion and/or all of the generative AI model described above.

Each of the input layer 1110, the hidden layer portion 1120, and the output layer 1130 may each include a respective set of nodes, and the strengths of respective connections between nodes (e.g., of adjacent layers) may be represented by respective weights (connection weights). The nodes included in the input layer 1110, the hidden layer portion 1120, and the output layer 1130 may be connected to each other with a fully connected type of architecture, as a non-limiting example; any suitable neural network architecture may be used.

In some embodiments, the number of parameters (the weights and biases) may be equal to the number of connections within the neural network 1100. The input layer 1110 may include input nodes ($x_1$ to $x_i$), and the number of input nodes ($x_1$ to $x_i$) may correspond to the number of independent variables of input data (e.g., number of pixels in, or features of, a target/training pattern).

For training the AI model, a data set may be input to the input layer 1110. When a mask image of an inference target is input to the input layer 1110 of the now-trained AI model, an inferred/predicted mask image may be output as the inference result from the output layer 1130 of the trained AI model 1100.

The hidden layer portion 1120 may be positioned between the input layer 1110 and the output layer 1130, and may include hidden layers $1120_1$ to $1120_n$ (possibly only one). The output layer 1130 includes at least one output node. An activation function may be used in the hidden layers 1120 and output layer 1130 to determine node outputs/activations.

In some embodiments, the AI model may be learned by updating the weights and/or parameters of a hidden node included in the hidden layer 1120.

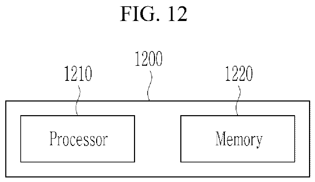

FIG. 12 illustrates a mask generation apparatus according to another embodiment. The mask generation apparatus may be implemented as a computer system, for example, as a computer-readable medium (but not a signal per se).

Referring to FIG. 12, the computer system 1200 includes at least one processor 1210 and a memory 1220. The memory 1220 may be connected to the processor 1210 and may store instructions causing the processor 1210 to perform steps or at least one program described above.

The processor 1210 may implement the functions, processes, and methods described herein. An operation of the computer system 1200 may be implemented by the processor 1210. At least one processor 1210 may include at least one of a GPU, a CPU, an NPU, FPGA, or DSP. In practice the processor 1210, may be one or more processors of one or more types. When the operation of the computer system 1200 is implemented by at least one processor 1210, each work may be divided according to the load among at least one processor 1210. For example, when one processor is a CPU, another processor may be any of a GPU, NPU, FPGA, or DSP.

In the embodiments described herein, the at least one memory 1220 may be positioned internally or externally to the processor and the memory may be connected to the processor via a variety of known means. The memory 1220 is a type of storage medium that may be volatile or non-volatile. For example, the memory 1220 may include a read-only memory (ROM) or a random access memory (RAM).

In another way, some functions (e.g., training the yield predicting model and/or the path generating model, inference by the yield predicting model and/or the path generating model) of the yield predicting device may be provided by a neuromorphic chip including neurons, synapses, and inter-neuron connection modules. The neuromorphic chip is a computer device simulating biological neural system structures, and may perform neural network operations.

Meanwhile, embodiments are not implemented only through the devices and/or methods described so far, but may also be implemented through a program (instructions) that realizes a function corresponding to the configuration of embodiments or a recording medium in which the program is recorded, and such implementation can be easily implemented by a person skilled in the art to which the present description belongs based on the description of the embodiments described above. Specifically, a method according to the embodiment (e.g., an image preprocessing method, etc.) can be implemented in the form of a program instruction that can be performed through various computer means and recorded on a computer-readable medium. The computer-readable medium may include program instructions, data files, data structures, etc., alone or in combination. The program instructions recorded on the computer-readable medium may be specially designed and configured for embodiment, or may be known and available to those skilled in the art of computer software. A computer-readable recording medium may include a hardware device configured to store and execute program instructions. For example, the computer-readable recording medium can be magnetic media such as hard disks, floppy disks, and magnetic tape, optical media such as CD-ROMs and DVDs, magneto-optical media such as floptical disks, ROM, RAM, flash memory, etc. Program instructions may include machine language code, such as that produced by a compiler, as well as high-level language code that can be executed by a computer through an interpreter, etc. Although the embodiments have been described in detail above, the scope of this disclosure is not limited thereto, and various modifications and improvements of a person of an ordinary skill in the art utilizing the basic concepts defined in the following claims also fall within the scope of this disclosure.

The computing apparatuses, the electronic devices, the processors, the memories, the image sensors, the displays, the information output system and hardware, the storage devices, and other apparatuses, devices, units, modules, and components described herein with respect to FIGS. 1-11 are implemented by or representative of hardware components. Examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-11 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as a multimedia card or a micro card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above disclosure, the scope of the disclosure may also be defined by the claims and their equivalents, and all variations within the scope of the claims and their equivalents are to be construed as being included in the disclosure.

In the embodiment of the description, the memory 1220 may be disposed inside or outside the processor, and the memory may be connected to the processor through various means already known. The memory may be a volatile or nonvolatile storage medium of various forms, and for example, the memory may include a read-only memory (ROM) or a random access memory (RAM).

On the other hand, the embodiments are not implemented only by the apparatus and/or the method as described above, but may be implemented by programs realizing the functions corresponding to the configuration of the embodiments or a recording medium recorded with the programs, which may be readily implemented by a person having ordinary skill in the art to which the description pertains from the description of the foregoing embodiments. Specifically, the method (e.g., a data augmentation method or the like) according to an embodiment may be implemented in the form of program instructions that may be executed through various computer means to be recorded on a computer-readable medium. The computer-readable medium may include program instructions, data files, data structures, and the like, independently or in combination thereof. The program instructions recorded on the computer-readable medium may be specially designed and configured for the embodiment, or may be known to those skilled in the art of computer software so as to be used. The computer-readable recording medium may include a hardware device configured to store and execute the program instructions. For example, the computer-readable recording medium may be a hard disk, a magnetic media such as a floppy disk and a magnetic tape, an optical media such as a CD-ROM and a DVD, a magneto-optical media such as a floptical disk, a ROM, a RAM, a flash memory, or the like. The program instructions may include a high-level language code that may be executed by a computer using an interpreter or the like, as well as a machine language code generated by a compiler.

**Claims**

1.  A method for generating a mask image for fabricating a mask, the method comprising:

    generating a first mask image from a target pattern using a first artificial intelligence, AI, model;
    determining a first loss function based on a difference between the first mask image and a corrected mask image of the first mask image that is corrected based on mask rules;
    updating the first AI model based on the first loss function; and
    generating a second mask image from the target pattern using the updated first AI model.

2.  The method of claim 1, wherein

the determining of the first loss function based on the difference between the mask image and the corrected mask image that is corrected based on the mask rule comprises performing an opening operation on the first mask image based on a first mask rule of a minimum pattern size.

3. The method of claim 2, wherein

the performing of the opening operation on the mask image comprises contracting a portion of the first mask image by a predetermined number of pixels and then expanding the portion of the first mask image by the predetermined number of pixels.

4. The method of claim 2, wherein

the updating of the first AI model based on the first loss function comprises updating, based on the first loss function, the first AI model to generate a mask image in which a pattern with a size less than the minimum pattern size is removed from the first mask image.

5. The method of any one of the previous claims, wherein

the determining of the first loss function based on the difference between the mask image and the corrected mask image that is corrected based on the mask rule comprises performing a closing operation on the mask image based on a second mask rule of minimum spacing between regions of the mask image.

6. The method of claim 5, wherein

the performing of the closing operation on the mask image based on the second mask rule of minimum spacing between regions of the mask image comprises expanding the first mask image by a predetermined number of pixels and then contracting the first mask image by the predetermined number of pixels; and optionally, wherein the updating of the first AI model based on the first loss function comprises updating, based on the first loss function, the first AI model to generate a mask image in which regions with spacing narrower than the minimum spacing become connected to each other.

7. The method of any one of the previous claims, further comprising:

predicting a casting pattern corresponding to the second mask image using a second AI model; and updating the first AI model based on a second loss function based on a difference between the target pattern and the predicted casting pattern.

8. The method of claim 1, further comprising

predicting a casting pattern corresponding to the first mask image by applying the second AI model to the first mask image, wherein the updating of the first AI model based on the first loss function comprises updating the first AI model based on the first loss function and a second loss function of loss between the target pattern and the predicted casting pattern.

9. An apparatus for generating a mask image for fabricating a mask, the apparatus comprising:

one or more processors; and a memory, wherein the memory stores instructions configured to cause the one or more processors perform a process comprising:

generating a first mask image from a target pattern using a first artificial intelligence, AI, model; determining a first loss function based on a difference between the first mask image and a corrected mask image of the first mask image that is corrected based on mask rules; updating the first AI model based on the first loss function; and generating a second mask image from the target pattern using the updated first AI model.

**10.** The apparatus of claim 9, wherein
the determining of the first loss function comprises
performing an opening or closing operation on the first mask image based on a first mask rule regarding a minimum size of a region or based on based on a second mask rule regarding a minimum spacing between regions; and, preferably, wherein the performing of the opening operation on the mask image comprises eroding the mask image and then dilating the mask image and the performing of the closing operation on the mask image based on the second mask rule regarding a minimum spacing between regions comprises dilating the mask image and then eroding the mask image.

**11.** The apparatus of claims 9 or 10, wherein the first AI model comprises a neural network that simulates photolithography, wherein the first mask image comprises an image of a photolithographic mask that photolithographically corresponds to the target pattern.

**12.** The apparatus of any one of claims 9-11, wherein the process further comprises inputting the first mask image to a second AI model that models light diffraction, the second AI model predicting a diffraction pattern based on the first mask image.

**13.** The apparatus of claim 12, wherein the process further comprises updating the first AI model based on the predicted diffraction pattern and the target pattern; wherein after the updating of the first AI model based on the predicted diffraction pattern and the target pattern the first AI model optionally generates another mask image in which regions with spacing narrower than a minimum spacing are deleted.

**14.** The apparatus of any one of claims 9-13, wherein the process further comprises:

predicting a diffraction pattern of the second mask image using a second AI model; and
updating the updated first AI model based on a second loss function between the target pattern and the predicted diffraction pattern.

**15.** The apparatus of any one of claims 9-14, wherein the process further comprising:

predicting a diffraction pattern of the first mask image using a second AI model, and
wherein the updating of the first AI model based on the first loss function comprises
updating the first AI model based on the first loss function and a second loss function based on a difference between the target pattern and the predicted diffraction pattern.

FIG. 1

Light source

Light

Mask

Pattern

Wafer

Photoresist

FIG. 2A

FIG. 2B

Mask

Exposure

Pattern on wafer surface

FIG. 2C

Mask

Exposure

Pattern on wafer surface

# FIG. 3

FIG. 4

```
        ( Start )
            │
            ▼
┌────────────────────────────────┐
│ First AI model is used to generate mask │ ──── S110
│    image from target pattern           │
└────────────────────────────────┘
            │
            ▼
┌────────────────────────────────┐
│ Second AI model is used to predict pattern │ ──── S120
│     to be generated by mask image         │
└────────────────────────────────┘
            │
            ▼
┌────────────────────────────────┐
│ Loss function is calculated based on difference between │ ──── S130
│  predicted pattern and target pattern and gradient     │
│       of loss function is backpropagated               │
└────────────────────────────────┘
            │
            ▼
┌────────────────────────────────┐
│ Update first AI model so that generated │ ──── S140
│   mask image complies with mask rule    │
└────────────────────────────────┘
            │
            ▼
         ( End )
```

FIG. 5

FIG. 6

: Original mask image

: Mask image after closing

: Difference image

FIG. 7

FIG. 8

: Original mask image

: Mask image after opening

: Difference image

FIG. 9

## FIG. 10

Start

First AI model is used to generate
mask image from target pattern — S210

Second AI model is used to predict pattern
to be generated by mask image — S220

Loss function is calculated based on difference
between predicted pattern and target pattern and
target pattern and gradient of loss function is backpropagated — S230

Update mask image so that generated mask image
complies with mask rule — S240

End

FIG. 11

FIG. 12

Processor 1210

Memory 1220

1200

**EP 4 600 735 A1**

| | Europäisches Patentamt European Patent Office Office européen des brevets | **EUROPEAN SEARCH REPORT** | **Application Number** EP 25 15 5459 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2024/022854 A1 (ASML) 1 February 2024 (2024-02-01) | 1,8 | INV. G03F1/36 |
| A | * claims 1, 2 * | 2-7,9-15 | G03F1/70 |
| | ----- | | G03F7/00 |
| X | US 2023/185183 A1 (HU ET AL) 15 June 2023 (2023-06-15) | 1,8 | G06N3/045 |
| A | * claims 1, 5 * | 2-7,9-15 | |
| | ----- | | |
| X | US 2020/380362 A1 (CAO ET AL) 3 December 2020 (2020-12-03) | 1,8 | |
| A | * item 33+45; paragraph [0250] * | 2-7,9-15 | |
| | ----- | | |
| A | BIENIAS ET AL: "Insights Into The Behaviour Of Multi-Task Deep Neural Networks For Medical Image Segmentation", 2019 IEEE 29TH INTERNATIONAL WORKSHOP ON MACHINE LEARNING FOR SIGNAL PROCESSING (MLSP), 13 October 2019 (2019-10-13), pages 1-6, XP033645836, DOI: 10.1109/MLSP.2019.8918753 [retrieved on 2019-12-02] * 2.3. Our post-processing method * | 2-7,9-15 | |
| | ----- | | **TECHNICAL FIELDS SEARCHED (IPC)** G03F G06N |

The present search report has been drawn up for all claims

| Place of search | Date of completion of the search | Examiner |
|---|---|---|
| Munich | 1 July 2025 | Subke, Kai-Olaf |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 5459

This annex lists the patent family members relating to the patent documents cited in the above-mentioned European search report.
The members are as contained in the European Patent Office EDP file on
The European Patent Office is in no way liable for these particulars which are merely given for the purpose of information.

01-07-2025

| Patent document cited in search report | Publication date | Patent family member(s) | | Publication date |
|---|---|---|---|---|
| WO 2024022854 A1 | 01-02-2024 | CN | 119487444 A | 18-02-2025 |
| | | TW | 202422213 A | 01-06-2024 |
| | | WO | 2024022854 A1 | 01-02-2024 |
| US 2023185183 A1 | 15-06-2023 | CN | 115698850 A | 03-02-2023 |
| | | EP | 4162322 A1 | 12-04-2023 |
| | | JP | 7532550 B2 | 13-08-2024 |
| | | JP | 2023528208 A | 04-07-2023 |
| | | JP | 2024156795 A | 06-11-2024 |
| | | KR | 20230005381 A | 09-01-2023 |
| | | TW | 202201144 A | 01-01-2022 |
| | | TW | 202309683 A | 01-03-2023 |
| | | US | 2023185183 A1 | 15-06-2023 |
| | | WO | 2021244820 A1 | 09-12-2021 |
| US 2020380362 A1 | 03-12-2020 | CN | 111788589 A | 16-10-2020 |
| | | KR | 20200113240 A | 06-10-2020 |
| | | KR | 20220147716 A | 03-11-2022 |
| | | TW | 201939365 A | 01-10-2019 |
| | | TW | 202040441 A | 01-11-2020 |
| | | US | 2020380362 A1 | 03-12-2020 |
| | | WO | 2019162346 A1 | 29-08-2019 |

EPO FORM P0459

For more details about this annex : see Official Journal of the European Patent Office, No. 12/82